# EUROPÄISCHE PATENTSCHRIFT

(11) **EP 1 149 417 B1**
(45) Veröffentlichungstag und Bekanntmachung des Hinweises auf die Patenterteilung: **07.08.2002**
(21) Anmeldenummer: 00926851.7
(22) Anmeldetag: 10.04.2000
(51) Int. Cl.: H01L 21/98, H01L 25/065

(54) **VERFAHREN ZUR HERSTELLUNG VON DREIDIMENSIONALEN SCHALTUNGEN**
METHOD FOR PRODUCING THREE-DIMENSIONAL CIRCUITS
PROCEDE DE PRODUCTION DE CIRCUITS TRIDIMENSIONNELS

(30) Priorität: 31.05.1999 DE 19924935
(43) Veröffentlichungstag der Anmeldung: 31.10.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: BUCHNER, Reinhold, D-85774 Unterföhring (DE); RAMM, Peter, D-85270 Pfaffenhofen (DE)
(74) Vertreter: Schoppe, Fritz, Dipl.-Ing.
(86) Internationale Anmeldenummer: EP0003172
(87) Internationale Veröffentlichungsnummer: WO0074136

(56) Entgegenhaltungen:
- EP-A- 0 703 618
- EP-A- 0 703 619
- WO-A-95/09438

## Beschreibung

Die vorliegende Erfindung betrifft ein Verfahren zur Herstellung von dreidimensionalen Schaltungen, und insbesondere von dreidimensionalen integrierten Schaltungen.

Unter einer dreidimensionalen Integration wird die vertikale Verbindung von Bauelementen verstanden, die mittels Planartechnik hergestellt wurden. Die Vorteile eines dreidimensional integrierten mikroelektronischen Systems sind u.a. die bei gleichen Designregeln erreichbaren höheren Packungsdichten und Schaltgeschwindigkeiten gegenüber zweidimensionalen Systemen. Letzteres ist zum einen bedingt durch kürzere Leitungswege zwischen den einzelnen Bauelementen oder Schaltungen, zum anderen durch die Möglichkeit der parallelen Informationsverarbeitung. Die Steigerung der Leistungsfähigkeit des Systems ist bei Realisierung einer Verbindungstechnik mit örtlich frei wählbaren höchstintegrierbaren vertikalen Kontakten optimal.

Zur Herstellung dreidimensionaler Schaltungsanordnungen mit frei wählbaren vertikalen Kontakten sind bereits die nachfolgenden Verfahren bekannt:

Y. Akasaka, Proc. IEEE 74 (1986) 1703, schlägt vor, auf eine fertig prozessierte Bauelementeschicht polykristllines Silizium abzuscheiden und zu rekristallisieren, so daß in der rekristallisierten Schicht weitere Bauelemente gefertigt werden können. Nachteile dieser Methode sind die ausbeutereduzierende Degradation der Bauelemente in der unteren Ebene durch die hohe thermische Belastung beim Rekristallisierungsprozeß, sowie die notwendigerweise serielle Prozessierung des Gesamtsystems. Letzteres bedingt zum einen entsprechend lange Durchlaufzeiten bei der Fertigung und hat zum anderen eine Ausbeuteminderung durch Aufsummierung der prozeßbedingten Ausfälle zur Folge. Beides erhöht die Fertigungskosten beträchtlich gegenüber einer Prozessierung der einzelnen Ebenen getrennt voneinander in verschiedenen Substraten.

Aus Y. Hayashi u.a. Proc., 8th Int. Workshop on Future Electron Devices, 1990, S. 85, ist es bekannt, zunächst die einzelnen Beuelementeebenen getrennt voneinander in verschiedenen Substraten herzustellen. Anschließend werden die Substrate auf wenige Millimeter gedünnt, mit Vorder- und Rückseitenkontakten versehen und mittels eines Bondverfahrens vertikal verbunden. Für die Bereitstellung der Vorder- und Rückseitenkontakte sind jedoch Sonderprozesse erforderlich, die in der Standard-Halbleiterfertigung (CMOS) nicht vorgesehen sind, nämlich MOS-inkompatible Materialien (z.B. Gold) und die Rückseitenstrukturierung des Substrates.

Die US-A-4,939,568 beschreibt ein Verfahren zur Herstellung einer dreidimensionalen integrierten Schaltungsstruktur durch Stapelung einzelner integrierter Schaltungen (ICs = integrated circuits) zu einem Einzelchipstapel auf einem Trägersubstrat. Hierzu wird zunächst ein Substrat mit fertigprozessierten ICs in einzelne Chips unterteilt, womit die Prozessierung auf der Waferebene beendet ist. Die Chips werden getestet, und ein erster einzelner Chip wird mittels Thermokompression auf ein Trägersubstrat aufgebracht. Nach diesem Schritt wird ein weiterer Chip in gleicher Weise auf den ersten Chip aufgebracht. Es wird somit zunächst ein erster Chipstapel fertiggestellt, bevor mit der Herstellung eines weiteren Chipstapels auf einem anderen Trägersubstrat begonnen wird. Eine Weiterprozessierung der Chipstapel auf Waferebene ist mit diesem Verfahren daher nicht möglich.

Ein wesentlicher Nachteil der oben beschriebenen Verfahren ist dadurch bedingt, daß die in der Siliziumtechnologie zur Verfügung stehenden Geräte nur eine Bearbeitung (Prozessierung) von scheibenförmigen Substraten, den sogenannten Wafern, zulassen. Eine Prozessierung davon verschiedener Substrate, insbesondere von einzelnen Chips, ist nur in experimentellen Versuchsanlagen möglich, jedoch nicht im Rahmen einer industriellen Fertigung mit den geforderten hohen Ausbeuten.

Die US-A-4,954,875 beschreibt ein Verfahren zur dreidimensionalen Integration durch Stapelung einzelner Wafer, bei dem die Verbindung der einzelnen Bauelementeebenen über besonders geformte Vias (Durchgangslöcher) hergestellt wird. Beim Zusammenfügen von Substraten, die eine Vielzahl von identischen Bausteinen, den sogenannten Chips, enthalten, ergibt sich die resultierende Ausbeute eines mehrlagigen Systems aus dem Produkt der Einzelausbeuten. Dies führt dazu, daß die Ausbeute eines mehrere Bauelementeebenen umfassenden Systems, wie das der US-A-4,954,875 nach den bekannten Verfahren drastisch abnimmt. So erhält man bei einer Ausbeute einer Einzelebene von 80% bei einem Gesamtsystem aus 10 Ebenen nurmehr eine resultierende Gesamtausbeute von etwa 10%, womit ein derartiges System unwirtschaftlich wird und der Einsatz dieser Technik auf wenige spezielle Einsatzfelder beschränkt ist. Die Ausbeute eines Bauelementesubstrates hängt dabei auch von der Art der Schaltungen und des verwendeten Herstellungsprozesses ab. So erzielt man z.B. in der Fertigung von Speicherbausteinen sehr hohe Ausbeuten, während bei Logikbausteinen, wie Mikroprozessoren, eine deutlich geringere Ausbeute erreicht wird. Insbesondere wenn mehrere Arten solcher Schaltungen übereinandergestapelt werden, wird damit die Gesamtausbeute überproportional durch die Schaltungsart mit der geringsten Ausbeute bestimmt.

Die US-A-5,563,084 gegenüber der der Patentanspruch 1 abgegrenzt ist beschreibt ein Verfahren zur Herstellung einer dreidimensionalen integrierten Schaltung, mit dem unter Verwendung der üblichen industriellen Standardausrüstung auf Waferebene eine deutliche Ausbeutesteigerung gegenüber den bisher beschriebenen Verfahren erzielt wird. Bei diesem Verfahren werden zwei fertig prozessierte Substrate verbunden. Vorher wird jedoch das obere Substrat einem Funktionstest unterzogen, mit dem die intakten Chips des Substrats selektiert werden. Anschließend wird dieses Substrat von der Rückseite her gedünnt, in einzelne Chips zerlegt und nur selektierte, intakte Chips nebeneinander auf das mit einer Haftschicht versehene, untere Substrat justiert aufgebracht. Durch das Aufbringen von ausschließlich selektierten Chips wird zwar eine Ausbeutesteigerung erreicht, jedoch werden bei einem defekten Teilsystem weiterhin intakte Chips aufgebaut und damit verschwendet, so daß unnötige Kosten verursacht werden.

Der vorliegenden Erfindung liegt die Aufgabe zugrunde, ein gegenüber den oben beschriebenen Verfahren verbessertes Verfahren zur Herstellung einer dreidimensionalen integrierten Schaltung zu schaffen, mit dem unter Verwendung einer üblichen industriellen Standardausrüstung auf Waferebene eine hohe Systemausbeute bei geringen Kosten gegenüber bisher bekannten Verfahren erzielt wird.

Diese Aufgabe wird durch ein Verfahren nach Anspruch 1 gelöst. .

Die vorliegende Erfindung schafft ein Verfahren zur Herstellung von dreidimensionalen Schaltungen, bei dem zunächst ein erstes Substrat und ein zweites Substrat bereitgestellt werden, in denen jeweils eine Mehrzahl von Bauelementen angeordnet sind, die bezüglich ihrer Funktionsfähigkeit geprüft sind. Anschließend wird das zweite Substrat vereinzelt, um eine Mehrzahl von Einzelchips zu erhalten, wobei jeder Einzelchip zumindest ein Bauelement umfaßt. Nachfolgend werden die Einzelchips auf dem ersten Substrat angeordnet und mit dem ersten Substrat verbunden, so daß funktionsfähige Bau-elemente in dem ersten Substrat mit Einzelchips mit einem funktionsfähigen Bauelement verbunden sind, und daß nichtfunktionsfähige Bauelemente in dem ersten Substrat mit Chipelementen ohne Funktion verbunden sind, um eine dreidimensionale Gesamtstruktur zu erhalten. Abschließend wird die dreidimensionale Gesamtstruktur vereinzelt, um die dreidimensionalen Schaltungen zu erhalten.

Gemäß einem bevorzugten Ausführungsbeispiel umfaßt der Schritt des Bereitstellens des ersten und des zweiten Substrats zum einen das Herstellen des ersten Substrats durch das Bearbeiten eines ersten Halbleiterwafers, um in diesen eine Mehrzahl von Bauelementen zu bilden, durch das Bilden einer Metallisierungsstruktur zur Kontaktierung der Bauelemente, das Prüfen der Mehrzahl von Bauelementen in dem ersten Substrat auf ihre Funktionsfähigkeit, um funktionsfähige Bauelemente von nicht-funktionsfähigen Bauelementen unterscheiden zu können, das Herstellen des zweiten Substrats durch Bearbeiten eines zweiten Halbleiterwafers, um in diesem die Mehrzahl von Bauelementen zu bilden, und durch Bilden einer Metallisierungsstruktur, das und anschließende Prüfen der Mehrzahl von Bauelementen in dem zweiten Substrat auf ihre Funktionsfähigkeit, um so funtionsfähige Einzelchips von nicht-funktionsfähigen Einzelchips unterscheiden zu können.

Bei einem weiteren bevorzugten Ausführungsbeispiel werden als Chipelement ohne Funktion die nicht-funktionsfähigen Einzelchips verwendet, die mit nicht-funktionsfähigen Bauelementen in dem ersten Substrat verbunden werden.

Gemäß einem weiteren bevorzugten Ausführungsbeispiel kann das erste Substrat seinerseits bereits aus mehreren Bauelementelagen in Form von Bauelementestapeln bestehen, und ebenso können auf dem zweiten Substrat nach dem Aufbringen der Einzelchips vor dem Vereinzeln der Gesamtstruktur weitere Bauelementeebenen chipweise aufgebracht werden.

Insgesamt werden bei dem erfindungsgemäßen Verfahren bekannte und eingeführte Verfahrensschritte verwendet, so daß gemäß einem besonderen Vorteil der vorliegenden Erfindung keine neuen Prozesse entwickelt werden müssen. Ein Vorteil der vorliegenden Erfindung besteht darin, daß eine Bearbeitung auf Waferebene möglich bleibt.

Mit dem erfindungsgemäßen Verfahren werden nur intakte Chips jeweils auf intakte Chips der darunterliegenden Bauelementelagen aufgebracht, während auf defekte Chips der darunterliegenden Bauelementelagen ebenfalls defekte Chips aufgebracht werden. Damit wird in vorteilhafter Weise die Abhängigkeit der Ausbeute des Gesamtsystems von der Ausbeute der einzelnen prozessierten Substrate stark verringert. Es können jeweils nur einzelne defekte Chips einer Bauelementelage ausgesondert werden, so daß nicht mehr ganze Bauelementestapel aufgrund einer einzigen defekten Lage unbrauchbar werden. Durch das erfindungsgemäße Verfahren werden somit die Ausbeute bei der Herstellung dreidimensional integrierter Schaltungen deutlich gesteigert und die gleichzeitig die Herstellungskosten gesenkt.

Bevorzugte Weiterbildungen der vorliegenden Anmeldung sind in den Unteransprüchen definiert.

Nachfolgend werden anhand der beiliegenden Zeichnungen bevorzugte Ausführungsbeispiele der vorliegenden Erfindung näher erläutert. Es zeigen:
- Fig. 1: eine schematische Darstellung des erfindungsgemäßen Verfahrens gemäß einem ersten Ausführungsbeispiel,
- Fig. 2: eine schematische Darstellung einer sich ergebenden dreidimensionalen Gesamtstruktur gemäß dem erfindungsgemäßen Verfahren nach einem zweiten Ausführungsbeispiel, und
- Fig. 3a-g: Einzelschritte des erfindungsgemäßen Verfahrens nach einem dritten Ausführungsbeispiel.

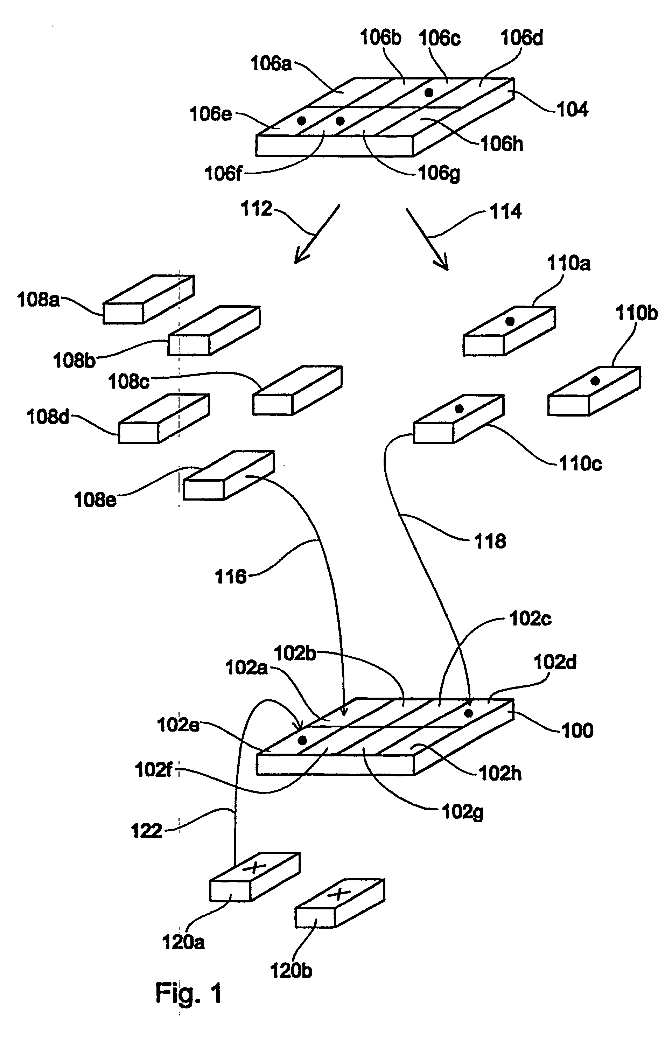

Anhand der Fig. 1 wird nachfolgend ein erstes, bevorzugtes Ausführungsbeispiel des erfindungsgemäßen Verfahrens zur Herstellung von dreidimensionalen Schaltungen näher erläutert. Hinsichtlich der nachfolgenden Beschreibung wird darauf hingewiesen, daß für gleiche oder ähnliche Elemente in den unterschiedlichen Figuren gleiche Bezugszeichen verwendet werden.

Zunächst wird ein erstes Substrat 100 bereitgestellt, in dem eine Mehrzahl von Bauelementen 102a - 102h angeordnet ist, die in Fig. 1 lediglich schematisch gezeigt sind. Diese einzelnen Bauelemente 102a - 102h können beispielsweise Speicherbausteine oder Logikbausteine, wie z.B. Mikroprozessoren, sein, wobei vorteilhafter Weise in einem Substrat lediglich eine Bauelementart gebildet ist. Ferner wird darauf hingewiesen, daß die Darstellung nicht maßstabsgerecht ist, und aus Gründen der Übersichtlichkeit lediglich eine geringe Anzahl von Bauelementen dargestellt ist, wobei jedoch offensichtlich ist, daß bei einer Realisierung eines solchen Substrats 100 eine Vielzahl von Bauelementen in diesem angeordnet sind.

Die in dem ersten Substrat 100 angeordneten Bauelemente 102a - 102h sind bezüglich ihrer Funktionsfähigkeit geprüft, d.h. es wurde bereits ein Funktionstest durchgeführt, und die funktionsfähigen Bauelemente 102a - 102c und 102f - 102h weisen keine Markierung auf, wohingegen die nicht-funktionsfähigen Bauelemente 102d und 102e der einfachheithalber in der Zeichnung mit einem Punkt versehen sind.

Weiterhin wird ein zweites Substrat 104 bereitgestellt, in dem ebenfalls eine Mehrzahl von Bauelementen 106a - 106h angeordnet ist, wobei die Darstellung ähnlich ist wie bei dem oben beschriebenen ersten Substrat 100. Die Bauelemente 106a - 106h sind ebenfalls bezüglich ihrer Funktionsfähigkeit geprüft, wobei die nicht-funktionsfähigen Bauelemente 106c, 106e und 106f durch einen Punkt gekennzeichnet sind. Die funktionsfähigen Bauelemente 106a, 106b, 106d, 106g und 106h sind nicht besonders gekennzeichnet.

In einem nachfolgenden Schritt wird das zweite Substrat 104 vereinzelt, um eine Mehrzahl von funktionsfähigen Einzelchips 108a - 108e sowie eine Mehrzahl von nicht-funktionsfähigen Einzelchips 110a - 110c zu erhalten, wie dies durch die Pfeile 112 und 114 schematisch angedeutet ist. Die funktionsfähigen Einzelchips 108a - 108e enthalten die bezüglich der Funktionsfähigkeit geprüften und für gut befundenen Bauelemente 106a, 106b, 106d, 106g und 106h des zweiten Substrats 104, während die nicht-funktionsfähigen Einzelchips 110a - 110c die bezüglich ihrer Funktionsfähigkeit geprüften und für fehlerhaft befundenen Bauelemente 106c, 106e und 106f des zweiten Substrats enthalten.

In einem nachfolgenden Verfahrensschritt werden die funktionsfähigen Einzelchips 108a - 108e auf dem ersten Substrat 100 angeordnet und mit diesem verbunden, wobei die funktionsfähigen Einzelchips 108a - 108b mit den jeweiligen funktionsfähigen Bauelementen 102a - 102c und 102f - 102h des ersten Substrats 100 verbunden werden, wie dies schematisch durch den Pfeil 116 angedeutet ist.

Die nicht-funktionsfähigen Einzelchips 110a - 110c werden ebenfalls auf dem ersten Substrat 100 angeordnet und mit diesem verbunden, wobei bei dem dargestellten Ausführungsbeispiel die Anzahl der nicht-funktionsfähigen Einzelchips 110a - 110c größer ist als die Anzahl der nicht-funktionsfähigen Bauelemente 102d und 102e in dem ersten Substrat 100, so daß in diesem Fall lediglich zwei der nicht-funktionsfähigen Einzelchips 110a - 110c auf dem ersten Substrat 100 angeordnet werden und auf die oben beschriebene Art und Weise mit diesem verbunden werden, wie dies durch den Pfeil 118 schematisch gezeigt ist.

Hinsichtlich des fehlenden, funktionsfähigen Einzelchips bei dem dargestellten Beispiel wird darauf hingewiesen, daß in diesem Fall ein weiterer funktionsfähiger Einzelchip verwendet werden kann, der z.B. bei einem vorherigen Herstellungsverfahren nicht verwendet wurde.

Anstelle der oben beschriebenen Verwendung der nicht-funktionsfähigen Einzelchips 110a - 110c, die mit den nicht-funktionsfähigen Bauelementen des ersten Substrats 100 verbunden werden, können auch einfache Chipelemente ohne Funktion 120a und 120b verwendet werden, um mit den nicht-funktionsfähigen Bauelementen des ersten Substrats 100 verbunden zu werden, wie dies durch den Pfeil 122 angedeutet ist. Bei diesen Chipelementen ohne Funktion 120a, 120b, kann es sich beispielsweise um entsprechend dimensionierte Halbleiter geeigneter Größe ohne Struktur oder mit einer beliebigen Struktur handeln. Um diese Chipelemente ohne Funktion 120a-120b von den nicht-funktionsfähigen Einzelchips 110a -110c des zweiten Substrats 104 zu unterscheiden sind diese in den Darstellungen mit einem "x" gekennzeichnet.

Das Verbinden der Einzelchips mit den jeweiligen Bauelementen in dem ersten Substrat 100 umfaßt neben der mechanischen Verbindung auch die elektrische Verbindung zwischen den Bauelementen in dem ersten Substrat und den jeweiligen Einzelchips.

Nachdem alle Einzelchips auf dem ersten Substrat 100 angeordnet sind, ergibt sich eine dreidimensionale Gesamtstruktur, die in einem abschließenden Verfahrensschritt, der in Fig. 1 nicht gezeigt ist, vereinzelt wird, um so dreidimensionale Schaltungen zu erhalten.

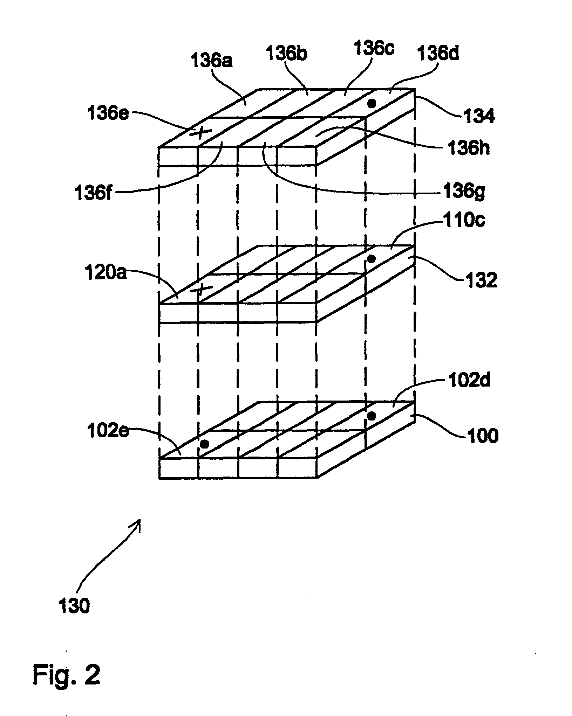

Anhand der Fig. 2 wird nachfolgend eine dreidimensionale Gesamtstruktur beschrieben, die sich gemäß dem erfindungsgemäßen Verfahren nach einem zweiten Ausführungsbeispiel ergibt. Die dreidimensionale Gesamtstruktur ist in ihrer Gesamtheit mit den Bezugszeichen 130 bezeichnet, und umfaßt das erste Substrat 100, auf dem in einer ersten Ebene 132 die Einzelchips, die durch Vereinzelung des zweiten Substrats 104 erhalten wurden, angeordnet sind, wie dies durch die gestrichelten Linien angedeutet ist. Ferner umfaßt die dreidimensionale Struktur 130 eine zweite Ebene 134, die eine Mehrzahl von Einzelchips 136a -136h umfaßt, die durch Vereinzelung eines dritten Substrats (nicht dargestellt) erhalten wurden. Dieses dritte Substrat umfaßt ebenfalls eine Mehrzahl von Bauelementen, die bezüglich ihrer Funktionsfähigkeit überprüft wurden, und durch die Vereinzelung des dritten Substrats sind die in Fig. 2 dargestellten Einzelchips 136a - 136h gebildet worden, wobei die Einzelchips 136a - 136c und 136f - 136h funktionsfähige Bauelemente umfassen, während die Einzelchips 136d und 136e nicht-funktionsfähige Bauelemente umfassen.

Hinsichtlich der Fig. 2 wird darauf hingewiesen, daß aus Übersichtlichkeitsgründen die Bezeichnung der einzelnen Chips in der zweiten Ebene bzw. der Bauelemente im ersten Substrat 100 mit Ausnahme der nicht-funktionsfähigen Teile weggelassen wurde.

Wie aus Fig. 2 weiter zu erkennen ist, erfolgt die Anordnung der Einzelchips 136a - 136h des dritten Substrats auf ähnliche Art und Weise, wie sie bereits oben anhand der Fig. 1 beschrieben wurde, nämlich derart, daß auf funktionsfähigen Einzelchips der zweiten Ebene 132 die funktionsfähigen Einzelchips der dritten Ebene 134 angeordnet und mit diesen Einzelchips in der zweiten Ebene 132 verbunden werden, und ebenso die nicht-funktionsfähigen Einzelchips der zweiten Ebene 134 mit den nicht-funktionsfähigen Einzelchips der ersten Ebene 132 verbunden werden.

Ferner wird darauf hingewiesen, daß in Fig. 2 bei Weglassung der zweiten Ebene 134 sich die dreidimensionale Gesamtstruktur gemäß dem anhand der Fig. 1 beschriebenen Verfahren ergibt.

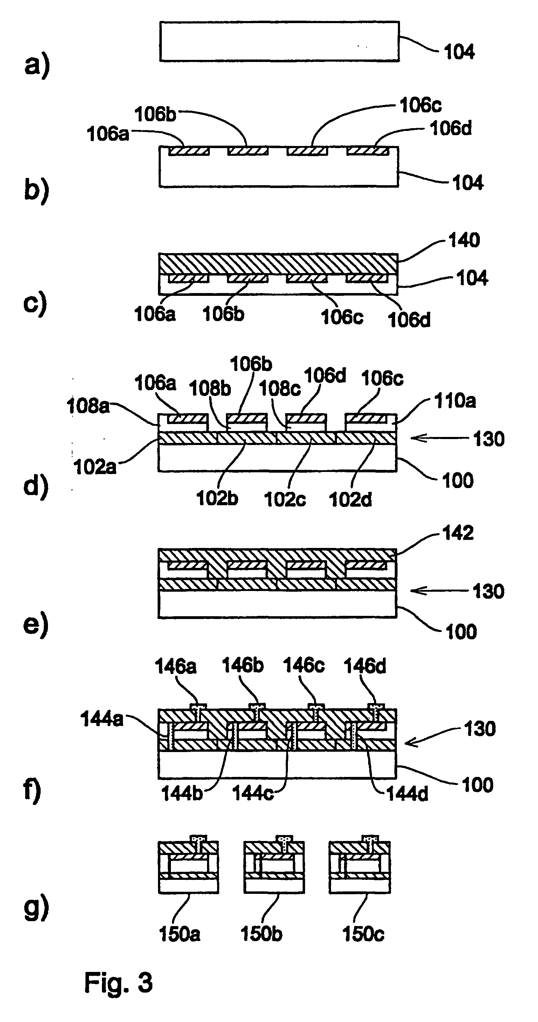

Anhand der Fig. 3 werden nachfolgend die Einzelschritte des erfindungsgemäßen Verfahrens nach einem dritten Ausführungsbeispiel näher beschrieben.

In Fig. 3a ist das unprozessierte zweite Substrat 104 dargestellt, in dem durch eine ansich bekannte Bearbeitung die einzelnen Bauelemente 106a - 106d gebildet werden, so daß sich die in Fig. 3b dargestellte Struktur ergibt. Anschließend wird, wie in Fig. 3c gezeigt ist, ein Hilfssubstrat 140 auf der Oberfläche des Substrats 104 gebildet, in der die Bauelemente 106a - 106d gebildet sind. Anschließend wird das Substrat 104 ausgehend von der Oberfläche, die der Oberfläche gegenüberliegt, an der das Hilfssubstrat 140 angeordnet ist, gedünnt. Anschließend wird das Substrat 104 vereinzelt, um die in Fig. 3d gezeigten funktionsfähigen Einzelchips 108a - 108c mit den funktionsfähigen Bauelementen 106a, 106b und 106d sowie den nicht-funktionsfähigen Einzelchip 110a mit dem nicht-funktionsfähigen Bauelement 106c zu schaffen. In Fig. 3d sind diese bereits auf dem ersten Substrat 100 angeordnet und mit diesem verbunden, wobei die entsprechenden Einzelchips 108a - 108c mit den funktionsfähigen Bauelementen 102a - 102c im ersten Substrat, und der nicht-funktionsfähige Einzelchip 110a mit dem nicht-funktionsfähigen Bauelement 102d im ersten Substrat 100 verbunden sind (analog zu der Beschreibung anhand der Fig.1). Wie zu erkennen ist, ergibt sich durch die Vereinzelung des zweiten Substrats 104 und die Anordnung der einzelnen Chips auf dem ersten Substrat 100 eine Schaltungsanordnung, bei der die Einzelchips durch Gräben voneinander getrennt sind. Wie aus Fig. 3d zu erkennen ist, wurde das Hilfssubstrat 140 nach dem Vereinzeln wieder entfernt.

Um eine weitere photolithographische Bearbeitung dieses Stapels zu ermöglichen, wird, wie in Fig. 3e gezeigt ist, durch Abscheiden einer weiteren Schicht 142 eine Planarisierung der sich ergebenden dreidimensionalen Gesamtstruktur 130 herbeigeführt.

Im nachfolgenden Schritt 3f erfolgt die Bildung der elektrischen Verbindungen zwischen den Einzelchips und den Bauelementen in dem ersten Substrat.

Wie zu erkennen ist, wird zwischen den einzelnen Bauelementen in den Chips sowie den einzelnen Bauelementen in dem ersten Substrat 100 eine elektrische Verbindung 144a - 144d auf an sich bekannte Art und Weise gebildet, und ebenso wird eine Kontaktierung 146a - 146d der Bauelemente in den einzelnen Chips an die Oberfläche der dreidimensionalen Gesamtstruktur 130 gebildet.

Anschließend wird die dreidimensionale Gesamtstruktur 130 vereinzelt, so daß sich die in Fig. 3g dargestellten einzelnen dreidimensionalen Schaltungen 150a - 150c ergeben. Diesbezüglich wird darauf hingewiesen, daß sich nur die dargestellten drei Schaltungen ergeben, nachdem die vierte Schaltung durch nicht-funktionsfähige Bauelemente gebildet ist, und daher ausgesondert wurde.

Bezüglich des oben beschriebenen Verfahrens wird darauf hingewiesen, daß das Dünnen des zweiten Substrats 104 z.B. durch Schleifen oder Ätzen erfolgen kann, und die verwendeten Substrate können z.B. monokristalline Siliziumsubstrate, SOI-Substrate oder III-V-Halbleitersubstrate sein.

Ferner wird darauf hingewiesen, daß gemäß einem bevorzugten Ausführungsbeispiel die Oberfläche des ersten Substrats 100, auf dem die Einzelchips aufgebracht werden, mit einer Haftschicht versehen sind.

Die vorliegende Erfindung schafft, wie aus der obigen Beschreibung deutlich wird, ein Verfahren, bei dem zwei fertig prozessierte Substrate 100, 104 (Wafer), die jeweils Schaltungsstrukturen 102a - 102h, 106a - 106h und Metallisierungsebenen 144a - 144d und 146a - 146d enthalten, beispielsweise über die Haftschicht miteinander verbunden werden. Diese Haftschicht kann hierbei zusätzlich eine passivierende Funktion ausüben und/oder eine Planarisierung der Oberfläche bewirken. Hierbei werden beide Substrate 100, 102 vor dem Verbinden einem Funktionstest unterzogen, mit dem die intakten Chips 102a - 102c, 102f - 102h und 106a, 106b, 106d, 106g und 106h ermittelt werden. Abschließend wird das obere (zweite Substrat) 104 von der Rückseite her gedünnt und in einzelne Chips 108a - 108e und 110a - 110c zerlegt. Diese Chips werden nun in die oben beschriebenen zwei Gruppen eingegliedert, nämlich in funktionstüchtige Chips 108a-108e und defekte Chips 110a - 110c. Danach werden die Chips der zweiten Bauelementeebene auf das mit einer Haftschicht versehene, untere Substrat 100 (erstes Substrat) nebeneinander justiert aufgebracht und damit zu einer neuen Chipebene 132 zusammengesetzt. Um nun sowohl eine hohe Systemausbeute als auch geringe Kosten zu erreichen, werden auf intakte Chips der unteren Ebene ausschließlich selektierte, intakte Chips der oberen Ebene aufgebracht, während auf defekte Chips der unteren Ebene nur defekte Chips der oberen Ebene aufgebracht werden. Alternativ kann statt einem defekten Chip auch ein entsprechend großes Stück aus einem Halbleitersubstrat 120a, 120b, das keine oder eine beliebige Struktur enthält, eingesetzt werden.

Das untere Substrat 100 kann hierbei auch bereits mehrere Bauelementelagen in Form von Bauelementestapeln enthalten. Die Chips des oberen Substrats 104 werden entweder im Rahmen des Verfahrens dem Funktionstest unterzogen oder es wird ein bereits geprüftes Substrat mit getesteten und z.B. markierten defekten Chips bereitgestellt und eingesetzt. Auf das obere Substrat 104 wird schließlich vor dem Dünnen und Zerteilen das Hilfssubstrat 140 aufgebracht. Statt des Dünnens des oberen Substrats bis nahe an die Bauelementelagen heran, kann im Falle eines SOI-Substrats der Substratbereich unterhalb der Oxidschicht entfernt werden.

Da auf dem unteren Substrat nun einzelne Chips aufgebracht worden sind, ist keine zusammenhängende Oberfläche mehr vorhanden - zwischen den Chips sind Gräben entstanden. Bestimmte Prozeßschritte, insbesondere Photolithographiemodule, können dann nicht mehr mit hoher Ausbeute durchgeführt werden. Daher wird nun vorzugsweise der oben beschriebene Planarisierungsschritt eingefügt.

Die weitere Vorgehensweise entspricht dem in der US-A-5,563,084 beschriebenen Verfahren.

Auf ähnliche Weise kann auch eine weitere Bauelementeebene 134 chipweise aufgebracht werden. Hierbei dient der bisher hergestellte Bauelementestapel mit zugehörigem Substrat als neues unteres Substrat. Bei dem erfindungsgemäßen Verfahren ist die Anzahl der Ebenen nicht beschränkt, und außerdem kann nicht nur eine Einzelebene, sondern auch ein bereits aus mehreren Ebenen bestehender Teilstapel chipweise aufgebracht werden.

## Patentansprüche

1. Verfahren zur Herstellung von dreidimensionalen Schaltungen mit folgenden Schritten:
a) Bereitstellen eines ersten Substrats (100) und eines zweiten Substrats (104), in denen jeweils eine Mehrzahl von Bauelementen (102a - 102h, 106a - 106h) angeordnet sind, wobei die Bauelemente des ersten Substrats bezüglich ihrer Funktionsfähigkeit geprüft sind;
b) Vereinzeln des zweiten Substrats (104), um eine Mehrzahl von Einzelchips (108a - 108e, 110a - 110c) zu erhalten, wobei jeder Einzelchip zumindest ein Bauelement umfaßt;
c) Anordnen der Einzelchips (108a - 108e, 110a - 110c) auf dem ersten Substrat (100) und Verbinden mit dem ersten Substrat (100), so daß funktionsfähige Bauelemente (102a - 102c, 102f - 102h) in dem ersten Substrat (100) mit Einzelchips (108a - 108e) mit einem funktionsfähigen Bauelement verbunden sind, um eine dreidimensionale Gesamtstruktur (130) zu erhalten; und
d) Vereinzeln der dreidimensionalen Gesamtstruktur (130), um dreidimensionale Schaltungen (150a - 150c) zu erhalten.
**dadurch gekennzeichnet,**
**daß** die Bauelemente des zweiten Substrats (104) bezüglich ihrer Funktionsfähigkeit geprüft sind,
und **daß** nicht-funktionsfähige Bauelemente (102a, 102e) in dem ersten Substrat (100) mit Chipelementen (110a - 110c, 120a -120b) ohne Funktion verbunden sind.

2. Verfahren nach Anspruch 1, bei dem die Chipelemente ohne Funktion Einzelchips (110a - 110c) sind, die durch die Vereinzelung des zweiten Substrats (104) erhalten werden und die ein nicht-funktionsfähiges Bauelement umfassen, oder ein Substrat (120a - 120b) geeigneter Größe sind, daß keine oder eine beliebige Struktur aufweist.

3. Verfahren nach Anspruch 1 oder 2, bei dem ein drittes Substrat bereitgestellt wird, in dem eine Mehrzahl von Bauelementen angeordnet ist, die bezüglich ihrer Funktionsfähigkeit überprüft sind, wobei das dritte Substrat in Einzelchips (136a - 136h) vereinzelt wird, die jeweils zumindest ein Bauelement umfassen, mit folgendem Schritt vor dem Schritt d):
Anordnen der Einzelchips (130a - 130h) des dritten Substrats auf und Verbinden der Einzelchips des dritten Substrats mit den Einzelchips des zweiten Substrats (104), so daß funktionsfähige Einzelchips des zweiten Substrats mit Einzelchips (136a - 136c, 136f - 136h) mit einem funktionsfähigen Bauelement des dritten Substrats verbunden sind, und daß nicht-funktionsfähige Einzelchip des zweiten Substrats mit Chipelementen (136d, 136e) ohneFunktion verbunden sind.

4. Verfahren nach einem der Ansprüche 1 bis 3, bei dem der Schritt c) das elektrische Verbinden der Bauelemente (102a - 102h) in dem ersten Substrat (100) mit den Einzelchips (108a - 108e, 110a - 110c, 120a - 120b) umfaßt.

5. Verfahren nach Anspruch 4, bei dem der Schritt des elektrischen Verbindens folgende Schritte umfaßt:
Planarisieren der Oberfläche der dreidimensionalen Gesamtstruktur (130); und
Bilden elektrischer Verbindungen (144a - 144d, 146a-146d) zwischen den Einzelchips und den Bauelementen in dem ersten Substrat (100).

6. Verfahren nach einem der Ansprüche 1 bis 5, bei dem der Schritt b) folgende Schritte umfaßt:
Verbinden einer Oberfläche des zweiten Substrats (104) mit einem Hilfssubstrat (140) ;
Dünnen des zweiten Substrats (104) von der der einen Oberfläche gegenüberliegenden Oberfläche aus; und
Vereinzeln des zweiten Substrats (104);
wobei das Hilfssubstrat (140) vor dem Schritt d) entfernt wird.

7. Verfahren nach Anspruch 6, bei dem das zweite Substrat (104) durch Schleifen oder Ätzen gedünnt wird.

8. Verfahren nach einem der Ansprüche 1 bis 7, bei dem das erste Substrat (100) eine dreidimensionale Gesamtstruktur ist, die gemäß den Schritten a) bis c) hergestellt ist.

9. Verfahren nach einem der Ansprüche 1 bis 8, bei dem die Einzelchips über eine Haftschicht mit dem ersten Substrat (100) verbunden werden.

10. Verfahren nach einem der Ansprüche 1 bis 9, bei dem das erste und das zweite Substrat (100, 104) ein monokristallines Siliziumsubstrat, ein SOI-Substrat oder III-V-Halbleitersubstrat ist.

11. Verfahren nach einem der Ansprüche 1 bis 10, bei dem der Schritt a) folgende Schritte umfaßt:
Herstellen des ersten Substrats (100) durch folgende Schritte :
- Bearbeiten eines ersten Halbleiterwafers, um in diesem die Mehrzahl von Bauelementen (102a - 102h) zu bilden; und
- Bilden einer Metallisierungsstruktur;
Prüfen der Mehrzahl von Bauelementen (102a - 102h) in dem ersten Substrat (100) auf ihre Funktionsfähigkeit, um funktionsfähige Bauelemente von nicht-funktionsfähigen Bauelementen unterscheiden zu können;
Herstellen des zweiten Substrats (104) durch folgende Schritte:
- Bearbeiten eines zweiten Halbleiterwafers, um in diesem die Mehrzahl von Bauelementen (106a - 106h) zu bilden; und
- Bilden einer Metallisierungsstruktur; und
Prüfen der Mehrzahl von Bauelementen (106a - 106h) des zweiten Substrats (104) auf Funktionsfähigkeit, um funktionsfähige Einzelchips von nicht-funktionsfähigen Einzelchips unterscheiden zu können.

## Claims

1. A method for producing three-dimensional circuits comprising the following steps:
a) providing a first substrate (100) and a second substrate (104), each of said substrates having arranged therein a plurality of components (102a - 102h, 106a - 106h), the components of the first substrate having been tested with regard to their operability;
b) dicing the second substrate (104) so as to obtain a plurality of individual chips (108a - 108e, 100a - 110c), each individual chip comprising at least one component;
c) arranging the individual chips (108a - 108e, 110a - 110c) on the first substrate (100) and connecting them to said first substrate (100) so that operative components (102a - 102c, 102f - 102h) in said first substrate (100) are connected to individual chips (108a - 108e) comprising an operative component so as to obtain a three-dimensional complete structure (130); and
d) dicing the three-dimensional complete structure (130) so as to obtain three-dimensional circuits (150a - 150c),
**characterized in that**
the components of said second substrate (104) have been tested with regard to their operability, and that non-operative components (102a, 102e) in said first substrate (100) are connected to chip elements (110a - 110c, 120a - 120b) having no function.

2. A method according to claim 1, wherein the chip elements having no function are individual chips (110a-110c) which are obtained by dicing the second substrate (104) and which include a non-operative component, or wherein they are a suitably sized substrate (120a - 120b) having no structure or an arbitrary structure.

3. A method according to claim 1 or 2, wherein a third substrate is provided, which has arranged therein a plurality of components that have been tested with regard to their operability, the third substrate being diced into individual chips (136a - 136h) which each include at least one component, the following step being carried out prior to step d):
arranging the individual chips (130a - 130h) of the third substrate on and connecting said individual chips of the third substrate to the individual chips of the second substrate (104) so that operative individual chips of the second substrate are connected to individual chips (136a - 136c, 136f - 136h) including an operative component of the third substrate, and that non-operative individual chips of the second substrate are connected to chip elements (136d, 136e) having no function.

4. A method according to one of the claims 1 to 3, wherein step c) comprises the electrical connection of the components (102a - 102h) in the first substrate (100) to the individual chips (108a - 108e, 110a-110c, 120a - 120b).

5. A method according to claim 4, wherein the step of electrically connecting comprises the following steps:
rendering the surface of the three-dimensional complete structure (130) planar; and
forming electric connections (144a - 144d, 146a-146d) between the individual chips and the components in the first substrate (100).

6. A method according to one of the claims 1 to 5, wherein step b) comprises the following steps:
connecting a surface of the second substrate (104) to an auxiliary substrate (140);
thinning the second substrate (104) from the surface located opposite said first-mentioned surface; and
dicing the second substrate (104);
the auxiliary substrate (140) being removed prior to step d).

7. A method according to claim 6, wherein the second substrate (104) is thinned by grinding or etching.

8. A method according to one of the claims 1 to 7, wherein the first substrate (100) is a three-dimensional complete structure which is produced according to steps a) to c).

9. A method according to one of the claims 1 to 8, wherein the individual chips are connected to the first substrate (100) via an adhesive layer.

10. A method according to one of the claims 1 to 9, wherein the first (100) and the second substrate (104) are a monocrystalline silicon substrate, an SOI substrate or a III-V semiconductor substrate.

11. A method according to one of the claims 1 to 10, wherein step a) comprises the following steps:
producing the first substrate (100) by the following steps:
- processing a first semiconductor wafer so as to form the plurality of components (102a - 102h) therein; and
- forming a metallization structure;
testing the plurality of components (102a - 102h) in said first substrate (100) with regard to their operability so as to be able to differentiate between operative components and non-operative components;
producing the second substrate (104) by the following steps:
- processing a second semiconductor wafer so as to form the plurality of components (106a - 106h) therein; and
- forming a metallization structure; and
testing the plurality of components (106a - 106h) of said second substrate (104) with regard to their operability so as to be able to differentiate between operative individual chips and non-operative individual chips.

## Revendications

1. Procédé de production de circuits tridimensionnels, aux étapes suivantes consistant à :
a) préparer un premier substrat (100) et un second substrat (104) dans chacun desquels sont disposés une pluralité de composants (102a à 102h, 106a à 106h), les composants du premier substrat étant contrôlés quant à leur capacité de fonctionnement;
b) diviser le second substrat (18), pour obtenir une pluralité de puces individuelles (108a à 108e, 110a à 110c), chaque puce individuelle comportant au moins un composant ;
c) disposer les puces individuelles (108a à 108e, 110a à 110c) sur le premier substrat (100) et les assembler avec le premier substrat (100), de sorte que les composants opérationnels (102a à 102c, 102f à 102h) dans le premier substrat (100) soient assemblés avec des puces individuelles (108a à 108e) à composant opérationnel, pour obtenir une structure d'ensemble tridimensionnelle (130); et
d) diviser la structure d'ensemble tridimensionnelle (130), pour obtenir des circuits tridimensionnels (150a à 150c),
**caractérisé par le fait**
**que** les composants du second substrat (104) sont contrôlés quant à leur capacité de fonctionnement,
et **que** les composants non opérationnels (102a, 102e) dans le premier substrat (100) sont assemblés avec des éléments de puce (110a à 110c, 120a à 120b) sans fonction.

2. Procédé selon la revendication 1, dans lequel les éléments de puce sans fonction sont des puces individuelles (110a à 110c) obtenues par la division du second substrat (104) et comportant un composant non opérationnel, ou sont un substrat (120a à 120b) de grandeur appropriée ne présentant pas de structure ou présentant une structure au choix.

3. Procédé selon la revendication 1 ou 2, dans lequel il est préparé un troisième substrat dans lequel sont disposés une pluralité de composants contrôlés quant à leur capacité de fonctionnement, le troisième substrat étant divisé en puces individuelles (136a à 136h) comportant, chacune, au moins un composant, à l'étape suivante, avant l'étape d), consistant à:
disposer les puces individuelles (136a à 136h) du troisième substrat sur et assembler les puces individuelles du troisième substrat avec les puces individuelles du second substrat (104), de sorte que les puces individuelles opérationnelles du second substrat soient assemblées avec des puces individuelles (136a à 136c, 136f à 136 h) à composant opérationnel du troisième substrat et que les puces individuelles non opérationnelles du second substrat soient assemblées avec des éléments de puce (136d, 136e) sans fonction.

4. Procédé selon l'une des revendications 1 à 3, dans lequel l'étape c) comprend la connexion électrique des composants (102a à 102h) dans le premier substrat (100) avec les puces individuelles (108a à 108e, 110a à 110c, 120a à 120b).

5. Procédé selon la revendication 4, dans lequel l'étape de connexion électrique comporte les étapes suivantes consistant à :
aplanir la surface de la structure d'ensemble tridimensionnelle (130) ; et
réaliser des connexions électriques (144a à 144d, 146a à 146d) entre les puces individuelles et les composants dans le premier substrat (100).

6. Procédé selon l'une des revendications 1 à 5, dans lequel l'étape b) comprend les étapes suivantes consistant à :
assembler une surface du second substrat (104) avec un substrat auxiliaire (140);
amincir le second substrat (104) depuis la surface opposée à l'une surface ; et
diviser le second substrat (104),
le substrat auxiliaire (140) étant éliminé avant l'étape d).

7. Procédé selon la revendication 6, dans lequel le second substrat (104) est aminci par meulage ou par gravure.

8. Procédé selon l'une des revendications 1 à 7, dans lequel le premier substrat (100) est une structure d'ensemble tridimensionnelle produite selon les étapes a) à c).

9. Procédé selon l'une des revendications 1 à 8, dans lequel les puces individuelles sont assemblées au premier substrat (100) par l'intermédiaire d'une couche adhésive.

10. Procédé selon l'une des revendications 1 à 9, dans lequel le premier et le second substrat (100, 104) sont, chacun, un substrat en silicium monocristallin, un substrat SOI ou un substrat à semi-conducteur III-V.

11. Procédé selon l'une des revendications 1 à 10, dans lequel l'étape a) comprend les étapes suivantes consistant à :
produire le premier substrat (100) par les étapes suivantes consistant à :
- usiner une première plaquette à semi-conducteur, pour former dans celle-ci la pluralité de composants (102a à 102h); et
- former une structure de métallisation;
contrôler la pluralité de composants (102a à 102h) dans le premier substrat (100) quant à leur capacité de fonctionnement, afin de pouvoir distinguer les composants opérationnels des composants non opérationnels ;
produire le second substrat (104) par les étapes suivantes consistant à :
- usiner une seconde plaquette à semi-conducteur, pour former dans celle-ci la pluralité de composants (106a à 106h) : et
- former une structure de métallisation; et
contrôler la pluralité de composants (106a à 106h) du second substrat (104) quant à leur capacité de fonctionnement, afin de pouvoir distinguer les puces individuelles opérationnelles des puces individuelles non opérationnelles.
